# EUROPEAN PATENT APPLICATION

(11) **EP 1 741 668 A2**
(43) Date of publication of application: **10.01.2007**
(21) Application number: 06253378.1
(22) Date of filing: 28.06.2006
(51) Int. Cl.: B81B 7/00

(54) **Method for encasing a MEMS device and packaged device**

(30) Priority: 05.07.2005 JP 2005196672
(71) Applicant: SHINKO ELECTRIC INDUSTRIES CO., LTD., Nagano-shi, Nagano 381-2287 (JP)
(72) Inventor: Koizumi, Naoyuki c/o Shinko Electric Ind. Co., Ltd, Nagano-shi, Nagano 381-2287 (JP)
(74) Representative: Rees, Alexander Ellison

(57) **Abstract**

A disclosed semiconductor device includes a substrate, an element provided on the substrate, an encasing structure encasing the element and including an organic material part formed of an organic material, and a protective film covering the organic material part. The protective film is formed of an inorganic material.

## Description

### BACKGROUND OF THE INVENTION

### 1. Field of the Invention

The present invention generally relates to a semiconductor device and a method of manufacturing a semiconductor device, and more particularly to a semiconductor device having an encasing structure and a method for manufacturing the semiconductor device.

### 2. Description of the Related Art

Although there are many kinds of elements formed on or mounted on a substrate, there are some elements that are preferred to be provided encased on the substrate.

One example preferred to be encased on a substrate is an element using a MEMS (Micro Electro Mechanical System) (hereinafter referred to as "MEMS element").

The MEMS element includes, for example, a pressure sensor, an acceleration sensor, and an optical function sensor. The MEMS elements are preferred to be used in a vacuum state, a decompressed state, or where the atmosphere is replaced with inert gas. Furthermore, the element is preferred to be encased so as to be hermetically sealed (airtight).

Various methods for encasing the MEMS element have been proposed (e.g. Japanese Laid-Open Patent Application Nos.8-316496 and 2005-19966). One example is a method of forming a moisture resistant coating layer formed of a resin material that surrounds a semiconductor element. Another example is a method of sealing a semiconductor element by adhering silicon wafers together.

In the example of encasing the semiconductor element using a resin material, the resin material exhibits high gas permeability, to thereby cause difficulty in encasing the semiconductor element so as to be hermetically sealed (airtight).

The method of adhering, for example, silicon wafers (silicon material) together is one method of encasing an element using inorganic materials having low gas permeability. However, in order to encase the element with the silicon material, the silicon material has to be formed in complicated shapes. Fabricating the silicon material into such complicated shapes is costly and time-consuming. This adversely affects the productivity of manufacturing the semiconductor device.

### SUMMARY OF THE INVENTION

The present invention may provide a semiconductor device and a method of manufacturing a semiconductor that substantially obviates one or more of the problems caused by the limitations and disadvantages of the related art.

Features and advantages of the present invention will be set forth in the description which follows, and in part will become apparent from the description and the accompanying drawings, or may be learned by practice of the invention according to the teachings provided in the description. Objects as well as other features and advantages of the present invention will be realized and attained by a semiconductor device and a method of manufacturing a semiconductor particularly pointed out in the specification in such full, clear, concise, and exact terms as to enable a person having ordinary skill in the art to practice the invention.

To achieve these and other advantages and in accordance with the purpose of the invention, as embodied and broadly described herein, an embodiment of the present invention provides a semiconductor device including: a substrate; an element provided on the substrate; an encasing structure encasing the element, the encasing structure including an organic material part formed of an organic material; and a protective film covering the organic material part; wherein the protective film is formed of an inorganic material. This may allow an element formed on a substrate to be hermetically sealed (airtight) by a simple structure.

In the semiconductor device according to an embodiment of the present invention, the element may include a MEMS element. This may allow a MEMS element to be hermetically sealed.

In the semiconductor device according to an embodiment of the present invention, the organic material part may have the shape of a housing having an opening on one side, wherein the organic material part is attached to the substrate at the side where the opening is formed. This may allow an encasing structure to be formed easily.

In the semiconductor device according to an embodiment of the present invention, the encasing structure may further include a plurality of inorganic material parts formed of an inorganic material, wherein the organic material part includes a plurality of adhesive agent parts formed of an adhesive material for adhesively bonding to the plural inorganic material parts.

This also may allow an encasing structure to be formed easily.

In the semiconductor device according to an embodiment of the present invention, the plural inorganic material parts may include a planar-shaped ceiling part and a supporting part provided on the substrate for supporting the ceiling part. This may also allow an encasing structure to be formed easily.

In the semiconductor device according to an embodiment of the present invention, the element may include an optical function element, wherein the ceiling part includes a light transmission surface that is not covered by the protective film. This may allow the protective film to provide satisfactory hermetic sealing without affecting the optical property of an optical function element.

Furthermore, an embodiment of the present invention provides a method of manufacturing a semiconductor device including the steps of: a) providing an element on a substrate; b) encasing the element with an encasing structure including an organic material part formed of an organic material; and c) forming a protective film at least on the organic material part. This may allow a semiconductor device having an element formed on a substrate to be easily manufactured so that the element is hermetically sealed.

In the method of manufacturing a semiconductor device according to an embodiment of the present invention, the step a) may include a step of providing a MEMS element on the substrate. This may allow the MEMS element to be hermetically sealed.

Other objects and further features of the present invention will be apparent from the following detailed description when read in conjunction with the accompanying drawings.

### BRIEF DESCRIPTION OF THE DRAWINGS

Fig.1 is a schematic view showing a semiconductor device according to a first embodiment of the present invention;
Fig.2 is a schematic view showing a semiconductor device according to a second embodiment of the present invention;
Fig.3 is a schematic view showing a semiconductor device according to a third embodiment of the present invention;
Fig.4A is a schematic view for describing a method of manufacturing the semiconductor device shown in Fig.1 (Part 1);
Fig.4B is a schematic view for describing a method of manufacturing the semiconductor device shown in Fig.1 (Part 2);
Fig.4C is a schematic view for describing a method of manufacturing the semiconductor device shown in Fig.1 (Part 3);
Fig.5A is a schematic view for describing a method of manufacturing the semiconductor device shown in Fig.2 (Part 1);
Fig.5B is a schematic view for describing a method of manufacturing the semiconductor device shown in Fig.2 (Part 2);
Fig.5C is a schematic view for describing a method of manufacturing the semiconductor device shown in Fig.2 (Part 3);
Fig.5D is a schematic view for describing a method of manufacturing the semiconductor device shown in Fig.2 (Part 4);
Fig.6 is a schematic view for describing a method of manufacturing the semiconductor device shown in Fig.2 (Part 5) ;
Fig.7A is a schematic view for describing another method of manufacturing the semiconductor device shown in Fig.2 (Part 1);
Fig.7B is a schematic view for describing another method of manufacturing the semiconductor device shown in Fig.2 (Part 2);
Fig.7C is a schematic view for describing another method of manufacturing the semiconductor device shown in Fig.2 (Part 3);
Fig.7D is a schematic view for describing another method of manufacturing the semiconductor device shown in Fig.2 (Part 4);
Fig.7E is a schematic view for describing another method of manufacturing the semiconductor device shown in Fig.2 (Part 5); and
Fig.7F is a schematic view for describing another method of manufacturing the semiconductor device shown in Fig.2 (Part 6).

### DESCRIPTION OF THE PREFERRED EMBODIMENTS

In the following, embodiments of the present invention are described with reference to the accompanying drawings.

The semiconductor device according to an embodiment of the present invention has a configuration in which an element provided on a substrate is encased by an encasing structure. The encasing structure includes an organic material part that is formed of an organic material. A protective film, which is formed of an inorganic material, is provided on the organic material part of the encasing structure. The protective film has low gas permeability and provides a sufficient hermetically sealing (airtight) effect.
By forming the protective film on the encasing structure of the semiconductor device according to an embodiment of the present invention, the encasing structure can provide a greater hermetical sealing characteristic (airtight property) with respect to the element provided on the substrate.

Furthermore, since the encasing structure is able to attain a satisfactory airtight property with the protective film, the encasing structure can be formed by using an organic material that enables easy fabrication and molding of the encasing structure. Accordingly, the encasing structure can be easily fabricated. Furthermore, since the configuration of the encasing structure can include an organic material, the encasing structure can be formed, for example, by joining plural components together with an organic material. This simplifies the shapes of the components used in forming the encasing structure. Hence, the semiconductor device including the encasing structure can be easily manufactured at low cost.

Next, embodiments of the above-described semiconductor device and a method of manufacturing the semiconductor device are described in further detail with reference to the accompanying drawings.

### [First Embodiment]

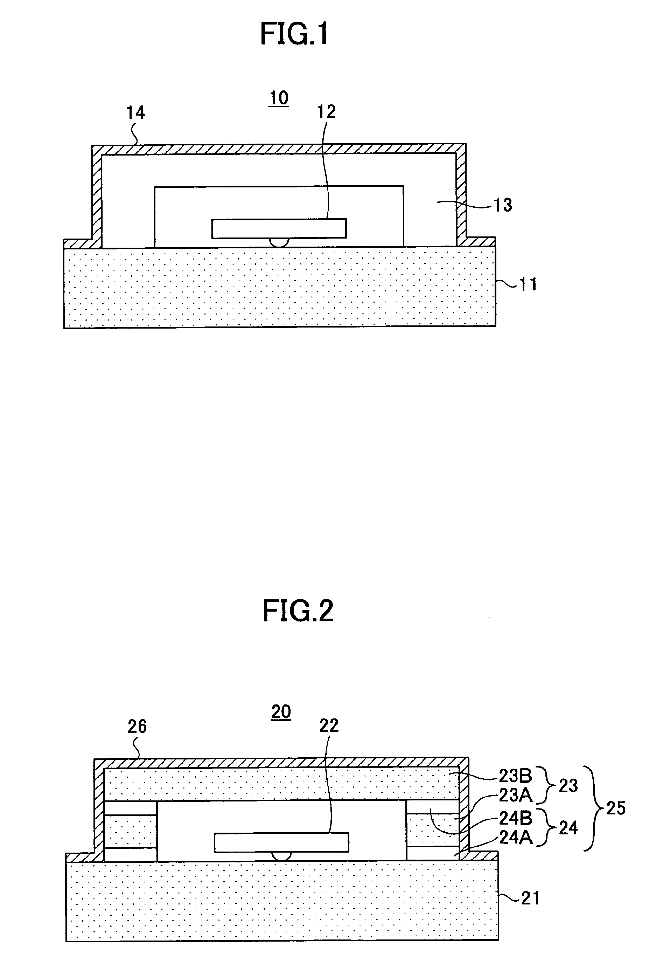

Fig.1 is a schematic diagram showing a semiconductor device 10 according to the first embodiment of the present invention. In Fig.1, the semiconductor device 10 includes a configuration having an element 12 formed on a substrate 11 and encased in an encasing structure 13. The substrate 11 is formed of a semiconductor material (e.g. silicon). The element 12 may be, for example, a MEMS element.

The encasing structure 13 includes an organic material (e.g. resin material). For example, the encasing structure 13 may be formed in a shape of a housing having an opening on one of its sides. In this example, the encasing structure 13 may be fixed on the substrate 11 by a resin type adhesive agent (not shown), to thereby encase the element 12 situated on the substrate 11 therein.

A protective film 14, which is formed of an inorganic material, is provided on the outer surface of the encasing structure 13 (opposite side of the surface facing the element 12) and the upper surface of the substrate 11 that continues from the outer surface of the encasing structure 13. Thereby, the element 12 can be hermetically sealed (airtight) inside the encasing structure 13. By forming the protective film 14 with an inorganic material, the encasing structure 13 will have low air permeability and be hermetically sealed. Accordingly, the encasing structure 13 is suitable for hermetically sealing an element (e.g. MEMS element) that is preferred to be used, for example, in a vacuum state, a decompressed state, or where the atmosphere is replaced with inert gas. Furthermore, the encasing structure 13 effectively prevents the element 12 from being exposed to moisture.

Although there are some conventional encasing structures formed of an inorganic material (e.g. silicon, glass), forming the conventional encasing structure requires considerable fabrication cost. This results in an increase of manufacturing cost of a semiconductor device including the conventional encasing structure. Furthermore, in a case of forming the conventional encasing structure with an organic material (e.g. resin material), although the conventional encasing structure can be easily fabricated (molded), such conventional encasing structure has high air permeability and therefore poor airtightness.

Accordingly, in the semiconductor device 10 according to the first embodiment of the present invention, a protective film 14 which is formed of an inorganic material having high hermetic sealing (airtightness) and water-sealing properties is provided on an encasing structure 13 formed of an organic material. By forming the encasing structure 13 with the organic material, the encasing structure 13 can be easily fabricated. In addition, by forming the protective film 14 on the surface of the encasing structure 13, the element 12 can be sufficiently hermetically sealed. By housing the element 12 in such a hermetically sealed condition, the element 12 can also be protected from moisture since gas (air) containing moisture, for example, can be prevented from permeating into the encasing structure 13.

The inorganic material of the protective film 14 includes, for example, a metal material (e.g. Ti, Ni, Cr, Al) and/or a non-metal material (e.g. SiN, SiON, Si₃N₄, SiO₂). The protective film 14 may be formed by using, for example, a CVD method or a PVD method (e.g. sputtering method).

The substrate 11 includes, for example, a wiring substrate. That is, the element 12 may be separately formed and mounted onto a substrate 11 such as a wiring substrate.

### [Second Embodiment]

Fig.2 is a schematic diagram showing a semiconductor device 20 according to a second embodiment of the present invention. In Fig.2, the semiconductor device 20 includes a substrate 21, an element 22, an encasing structure 25, and a protective film 26. The substrate 21, the element 22, and the protective film 26 correspond to the substrate 11, the element 12, and the protective film 14 described in the first embodiment and have the same configurations, respectively.

The encasing structure 25 according to the second embodiment corresponds to the encasing structure 13 of the first embodiment. However, the encasing structure 25 is different from the encasing structure 13 in that the encasing structure 25 includes a combination of an inorganic material part 23 formed of an inorganic material and an organic material part 24 formed of an organic material. The protective film 26 is provided on the outer surface of the encasing structure 25 including the organic material part 24 and the upper surface of the substrate 21 that continues from the outer surface of the encasing structure 25.

The encasing structure 25 includes a combination of an organic material and an inorganic material. For example, the encasing structure 25 may include a configuration having plural inorganic materials joined by one or more organic materials. Accordingly, compared to a case of manufacturing an encasing structure by integrally forming inorganic materials into a single body, the encasing structure 25 can be manufactured more easily by using separate inorganic material components having simple shapes. Thereby, manufacturing cost can be reduced.

In one example, the inorganic material part 23 includes a planar ceiling part 23B positioned in a manner facing the substrate 21 and a supporting part 23A positioned on the substrate 11 in a manner supporting the ceiling part 23B. The supporting part 23A may be formed, for example, as a square frame-like shape having a space in the middle for encompassing the element 22.

The organic material part 24 includes adhesive layers 24A, 24B that mainly include an organic material such as a resin material. The adhesive layer 24B bonds the ceiling part 23B and the supporting part 23A, and the adhesive layer 24A bonds the supporting part 23A and the substrate 21.

The protective film 26 hermetically sealing the element 22 is formed on the outer surface of the encasing structure 25 (opposite side of the surface facing the element 22) and the upper surface of the substrate 21. That is, the protective film 26 is formed on the adhesive layers 24A, 24B, the supporting part 23A, the ceiling part 23B, and the upper surface of the substrate 21. The protective film 26 enhances the hermetic sealing property and prevents gas from permeating particularly at areas of the encasing structure 25 having high gas permeability (in this case, the organic material part 24 including the adhesive layers 24A, 24B).

By forming the protective film 26 having a satisfactory hermetic sealing property on the encasing structure 25, the encasing structure 25 can be formed by using a combination of an organic material and an inorganic material. Accordingly, an adhesive agent formed of an organic material may be used in forming the encasing structure while maintaining a satisfactory hermetic sealing property. This increases the degree of freedom for fabricating the encasing structure. That is, the encasing structure can be formed having various configurations.

For example, compared to forming a conventional encasing structure by an anodic bonding method using an inorganic material, the encasing structure of the present invention can be formed with more ease and with less cost.

### [Third Embodiment]

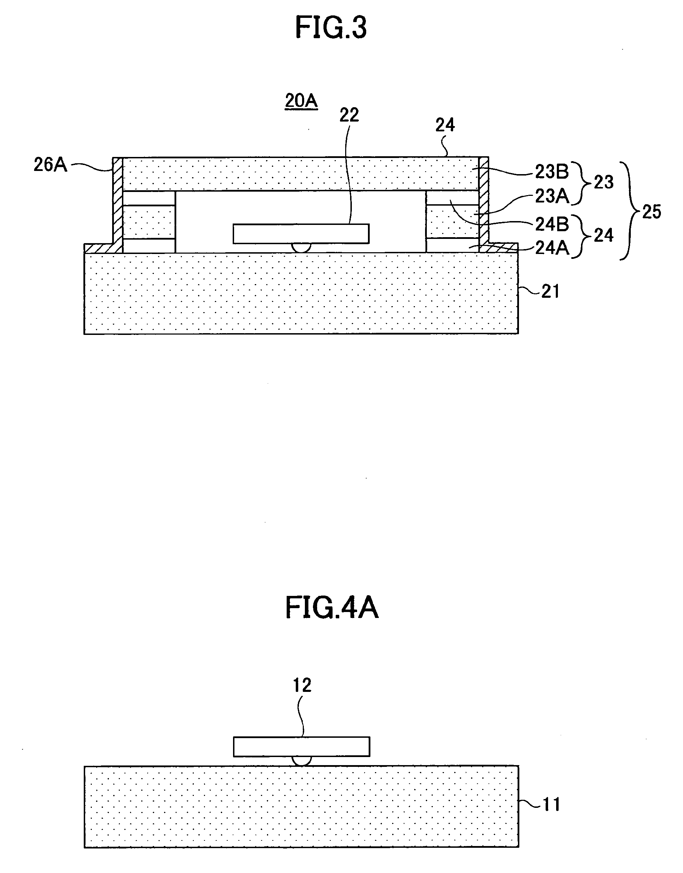

Fig.3 is a schematic diagram showing a semiconductor device 20A according to a third embodiment of the present invention. In Fig.3, like components are denoted with like numerals as of the above-described embodiments of the present invention and are not further described. The semiconductor device 20A includes a protective film 26A that basically corresponds to the protective film 26 described in the second embodiment. The protective film 26A, however, is not formed on the surface of the ceiling part 23B situated above the substrate 21, but is formed on the sides of the adhesive layers 24A, 24B, the sides of the supporting parts 23A, the sides of the ceiling part 23B, and the upper surface of the substrate 21.

For example, in a case where the element 22 has an optical function (e.g. light emitting function, photoelectric transferring function, reflecting function), the surface of the ceiling part 23B becomes a light transmission surface through which light is transmitted from the outside to the element 22 or from the element 22 to the outside. Accordingly, instead of forming the protective film 26A on the surface of the ceiling part 23B (light transmission surface), the surface of the ceiling part 23B is exposed.

Alternatively, in a case where the surface of the ceiling part 23B is a light transmission surface, a protective film having a predetermined optical characteristic may be formed on the light transmission surface. For example, the protective film may be an anti-reflection film or a filter for blocking a light beam of a predetermined wavelength.

In the above-described first-third embodiments of the present invention, a wiring and/or an external connecting terminal may be formed on the substrate (11, 21) for establishing electric connection with the element (12, 22) mounted on the substrate (11, 21).

Furthermore, in the semiconductor device described in the first-third embodiments, the element encased in the encasing structure is not limited to a MEMS element. Other semiconductor elements may also be encased. For example, the element (12, 22) may have an optical function such as a photoelectric transfer element (e.g. photodiode) or a light emitting element (e.g. LED), in which its light receiving surface or light emitting surface can be protected from dust and other foreign matter.

### [Fourth Embodiment]

Next, an example of a method of manufacturing the semiconductor device 10 shown in Fig.1 is described with reference to Figs.4A-4C. In Figs.4A-4C, like components are denoted with like numerals as of the above-described embodiments and are not further described.

In the step shown in Fig.4A, an element 12 is formed on a substrate 11. The substrate 11 includes a semiconductor material such as silicon or GaAs. The element 12 may be, for example, a MEMS element. In the step shown in Fig.4A, the substrate 11 may be a wiring substrate including wiring for connecting with the element 12 mounted on the substrate 11.

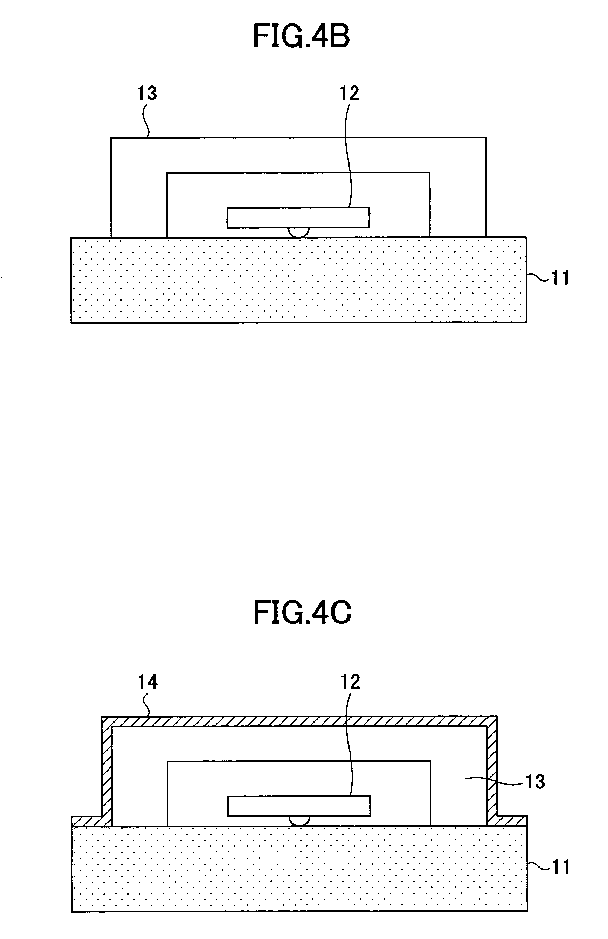

Next, in the step shown in Fig.4B, an encasing structure 13 is fixed on the substrate 11 by a resin type adhesive agent (not shown) so that the element 12 situated on the substrate 11 is encased in the encasing structure 13. For example, the encasing structure 13 is formed, with a resin material, in the shape of a housing having an opening on one of its sides.

Next, in the step shown in Fig.4C, a protective film 14, which is formed of an inorganic material, is provided on the outer surface of the encasing structure 13 (opposite side of the surface facing the element 12) and the upper surface of the substrate 11 that continues from the outer surface of the encasing structure 13. The protective film 14 is formed by using a coating method including, for example, a sputtering method or a CVD method. The inorganic material of the protective film 14 includes, for example, a metal material (e.g. Ti, Ni, Cr, Al) and/or a non-metal material (e.g. SiN, SiON, Si₃N₄, SiO₂).

Thereby, the semiconductor device 10 according to the first embodiment of the present invention is formed.

### [Fifth Embodiment]

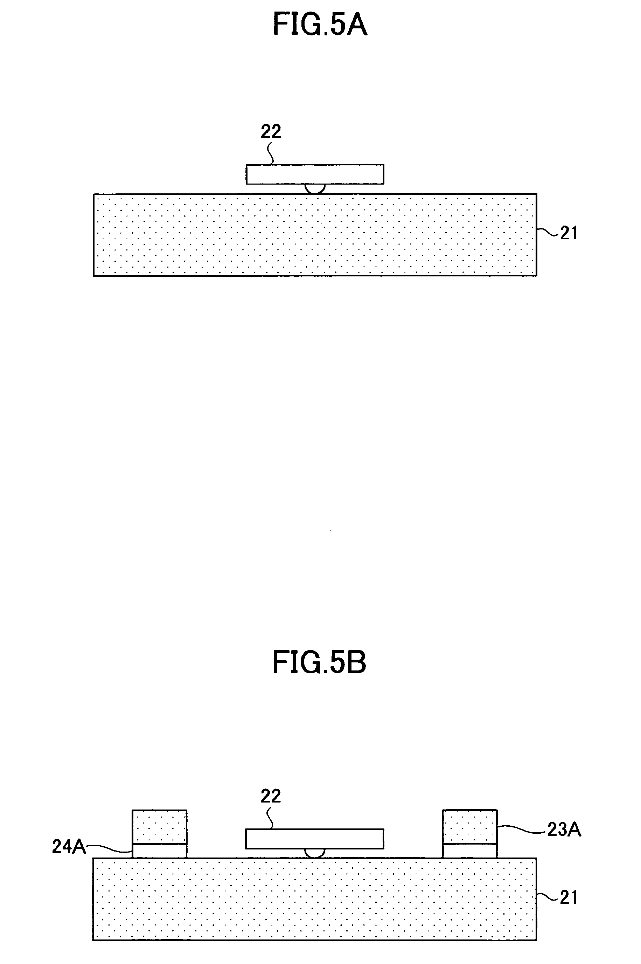

Next, an example of a method of manufacturing the semiconductor device 20 shown in Fig.2 is described with reference to Figs.5A-5D. In Figs.5A-5D, like components are denoted with liked numerals as of the above-described embodiments and are not further described.

In the step shown in Fig.5A, one or more elements 22 are formed on a substrate 21. The substrate 21 includes a semiconductor material such as silicon or GaAs. The element 22 may be, for example, a MEMS element. In the step shown in Fig.5A, the substrate 21 may be a wiring substrate including wiring for connecting with the element 22 mounted on the substrate 21.

Next, in the step shown in Fig.5B, a supporting part 23A and the substrate 21 are bonded together by providing an adhesive layer 24A therebetween. The supporting part 23A is formed of an inorganic material. The adhesive layer 24A includes, for example, a resin type adhesive agent.

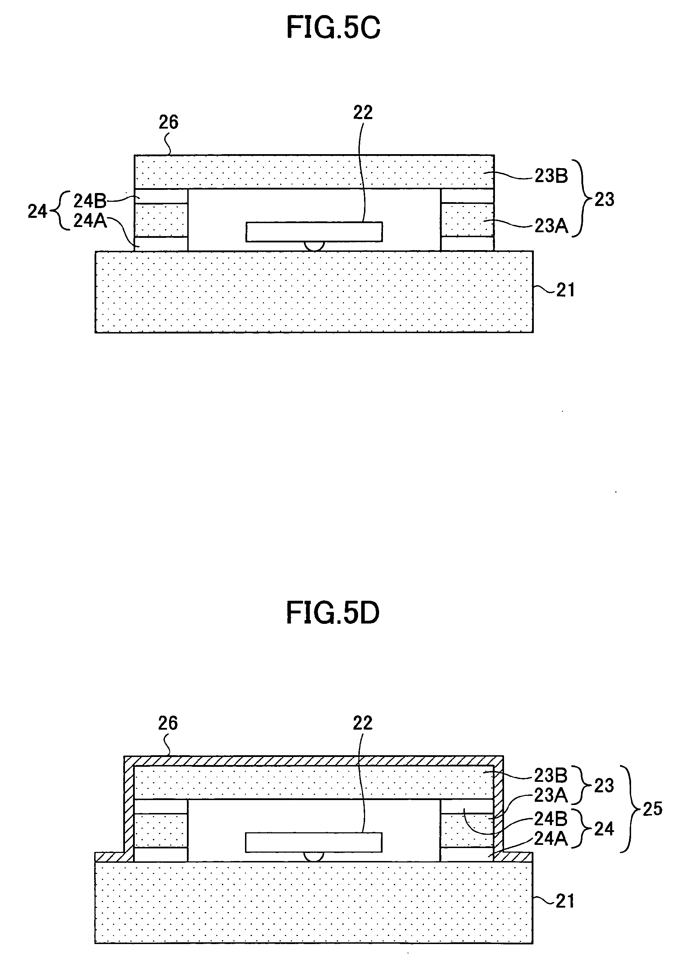

Next, in the step shown in Fig.5C, a planar ceiling part 23B and the supporting part 23A are bonded together by providing an adhesive layer 24B therebetween. The ceiling part 23B is a planar member which is also formed of an inorganic material. The adhesive layer 24B also includes, for example, a resin type adhesive agent. Thereby, the encasing structure(s) 25 encasing the element(s) is formed.

Next, in the step shown in Fig.5D, a protective film 26, which is formed of an inorganic material, is provided on the outer surface of the encasing structure 25 (opposite side of the surface facing the element 22) and the upper surface of the substrate 21 that continues from the outer surface of the encasing structure 25. The protective film 26 is formed by using the same coating method and inorganic material as described in the step shown in Fig.4C. Thereby, the semiconductor device 20 according to the second embodiment of the present invention is formed.

In a case of forming the semiconductor device 20A according to the third embodiment of the present invention (Fig.3), a mask layer (not shown) is formed on the surface of the ceiling part 23B of the encasing structure in the step shown in Fig.5C. After the mask layer is formed, the protective film 26A is formed on the upper surface of the substrate and the outer surface of the encasing structure except for the area where the mask layer is formed. After the protective layer 26A is formed, the mask layer is removed from the encasing structure.

In a case of forming (manufacturing) the above-described semiconductor devices 10, 20, 20A, multiple semiconductor devices 10, 20, 20A having the above-described corresponding configurations may be formed on a substrate and diced into respective semiconductor devices 10, 20, 20A.

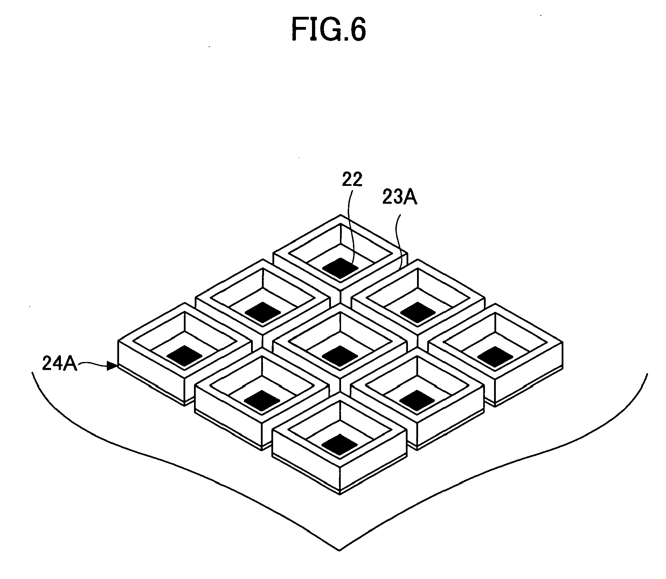

Fig.6 is a perspective viewing for describing an exemplary case of forming multiple semiconductor devices 10, 20, 20A and dicing them into respective units. Fig.6 shows the step of Fig.5B in which the supporting part 23A and the substrate 21 are bonded together by the adhesive layer 24A. After the supporting part 23A and the substrate 21 are bonded together, the ceiling part 23B and the supporting part 23A are bonded in a manner covering a perforation where the element 22 is exposed (thereby forming the encasing structure). After the encasing structure is formed, the protective layer is formed on the outer surface of the encasing structure and the substrate. After the protective layer is formed, the semiconductor devices including the encasing structures are diced into respective semiconductor devices.

For example, in a case of forming the encasing structure 25 by integrally forming inorganic materials into a single body, a considerable amount of time and money is spent performing an etching (dicing) operation on the encasing structure. However, by forming the encasing structure by joining separate inorganic material components, manufacturing the semiconductor device can be simplified and manufacturing cost can be reduced.

### [Sixth Embodiment]

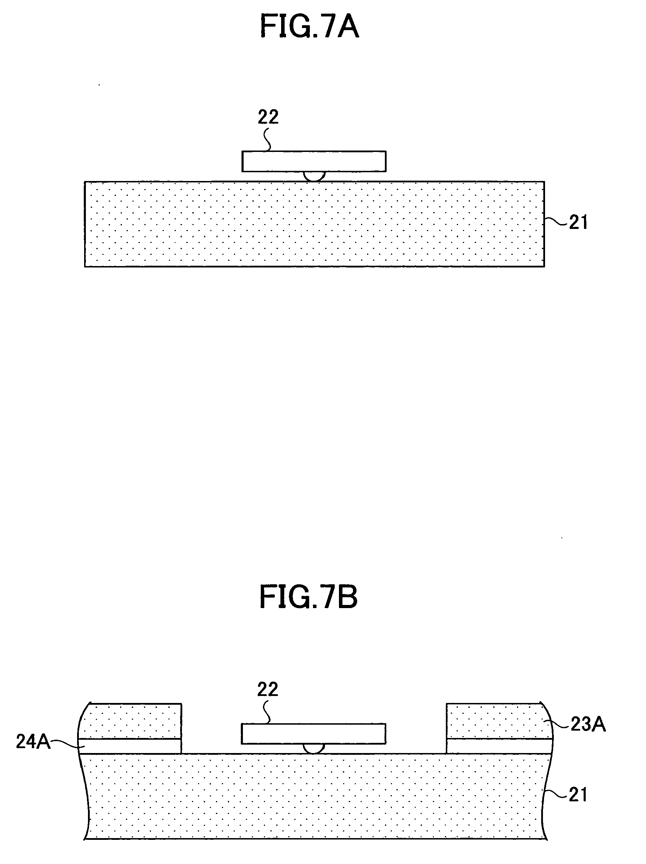

Next, another example of a method of manufacturing the semiconductor device 20 shown in Fig.2 is described with reference to Figs.7A-7F. In Figs.7A-7F, like components are denoted with liked numerals as of the above-described embodiments and are not further described.

In the step shown in Fig.7A, one or more elements 22 are formed on a substrate 21. The substrate 21 includes a semiconductor material such as silicon or GaAs. The element 22 may be, for example, a MEMS element. In the step shown in Fig.7A, the substrate 21 may be a wiring substrate including wiring for connecting with the element 22 mounted on the substrate 21.

Next, in the step shown in Fig.7B, a supporting part 23A and the substrate 21 are bonded together by providing an adhesive layer 24A therebetween. The supporting part 23A is formed of an inorganic material. The adhesive layer 24A includes, for example, a resin type adhesive agent. The step shown in Fig.7B of the sixth embodiment is different from the step shown in Fig.5B in that a planar member having plural perforations is used as the supporting part 23A. The planar supporting part 23A in the sixth embodiment is bonded with the substrate 21 so that one element 22 is disposed in each of the perforations of the supporting part 23A.

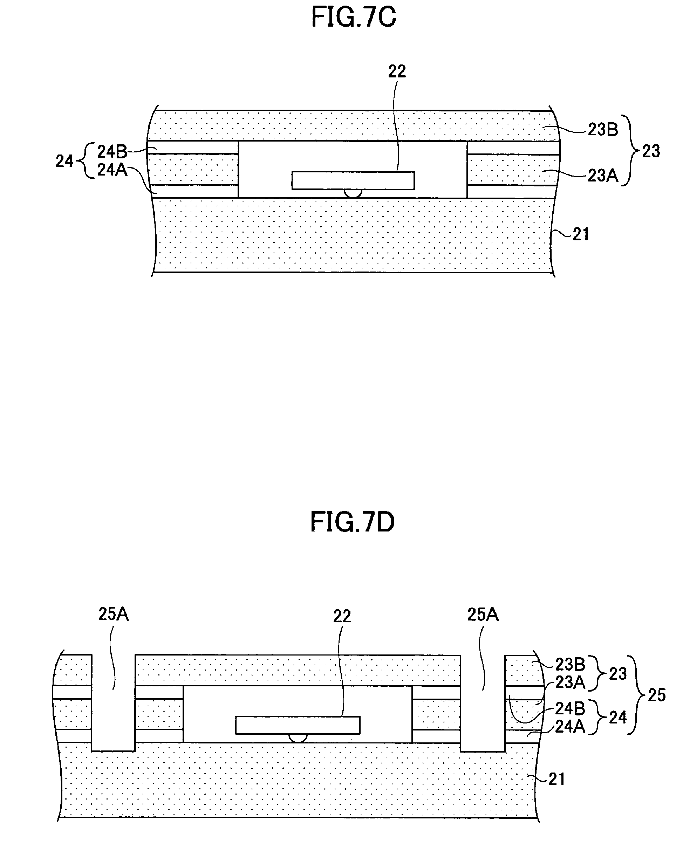

Next, in the step shown in Fig.7C, a planar ceiling part 23B and the supporting part 23A are bonded together by providing an adhesive layer 24B therebetween. The ceiling part 23B is a planar member which is also formed of an inorganic material. The adhesive layer 24B also includes, for example, a resin type adhesive agent. Thereby, the encasing structure(s) 25 encasing the element(s) is formed.

Next, in the step shown in Fig.7D, a groove part 25A is formed at the border area encompassing each encasing structure (semiconductor devices) so that a part of the substrate 21 is exposed. The groove part 25A is formed by dicing the supporting part 23A and the ceiling part 23B with, for example, a dicer used for dicing wafers. In forming the groove part 25A, it is preferable to cut (diced) a portion of the surface of the substrate 21 so that the adhesive layer 24A can be thoroughly covered by the protective film 26 that is formed in the subsequent step. Thereby, a sufficient hermetic sealing property can be attained.

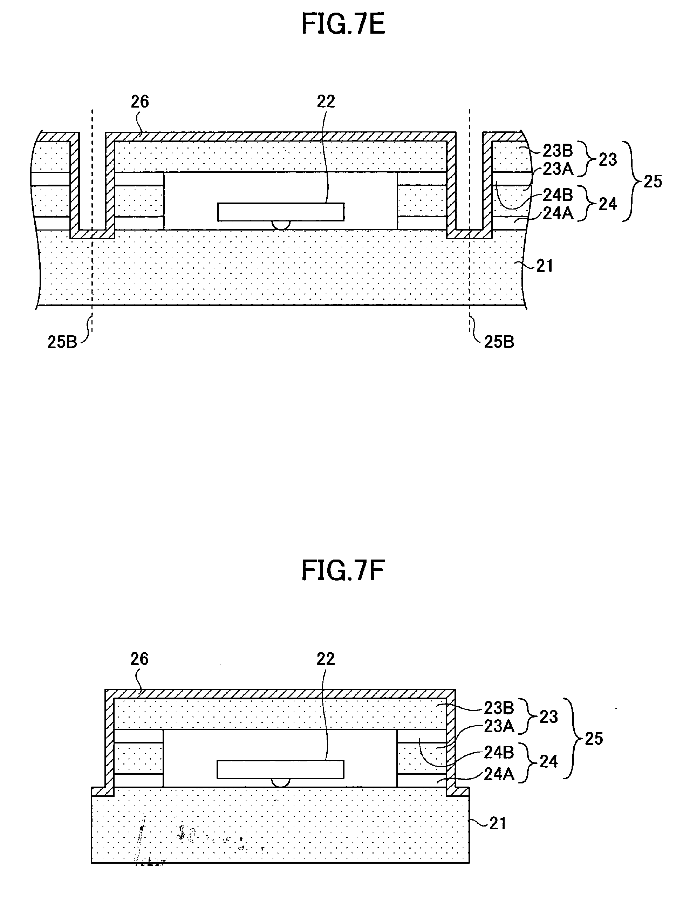

Next, in the step shown in Fig.7E, a protective film 26, which is formed of an inorganic material, is provided on the top surface of the ceiling part 23B and the inner wall surfaces of the groove part 25A. The protective film 26 is formed by using the same coating method and inorganic material as described in the step shown in Fig.4C. Then, the substrate 21 is cut (diced) from the bottom portion of the groove part 25A along a cutting line 25B (see Fig.7E). The cutting may be performed with, for example, a dicer used for dicing wafers.

Thereby, as shown in Fig.7F, the semiconductor device 20 according to the second embodiment of the present invention is formed. In the above-described manufacturing method of the sixth embodiment, the configuration formed by bonding the supporting part 23A and the ceiling part 23B can easily be obtained by attaching two simple-shaped members (in this embodiment, planar members) together. Accordingly, the process of cutting the supporting part 23A and the ceiling part 23B (forming the groove part 25B) can be conducted after the step of bonding the supporting part 23A and the ceiling part 23B.

Further, the present invention is not limited to these embodiments, but variations and modifications may be made without departing from the scope of the present invention.

## Claims

1. A semiconductor device **characterized by** comprising:
a substrate;
an element provided on the substrate;
an encasing structure encasing the element, the encasing structure including an organic material part formed of an organic material; and
a protective film covering the organic material part;
wherein the protective film is formed of an inorganic material.

2. The semiconductor device as claimed in claim 1, **characterized in that** the element includes a MEMS element.

3. The semiconductor device as claimed in claim 1, **characterized in that** the organic material part has a shape of a housing having an opening on one side, wherein the organic material part is attached to the substrate at the side where the opening is formed.

4. The semiconductor device as claimed in claim 1, **characterized in that** the encasing structure further includes a plurality of inorganic material parts formed of an inorganic material, wherein the organic material part includes a plurality of adhesive agent parts formed of an adhesive material for adhesively bonding to the plural inorganic material parts.

5. The semiconductor device as claimed in claim 4, **characterized in that** the plural inorganic material parts include a planar-shaped ceiling part and a supporting part provided on the substrate for supporting the ceiling part.

6. The semiconductor device as claimed in claim 5, **characterized in that** the element includes an optical function element, wherein the ceiling part includes a light transmission surface that is not covered by the protective film.

7. A method of manufacturing a semiconductor device **characterized by** comprising the steps of:
a) providing an element on a substrate;
b) encasing the element with an encasing structure including an organic material part formed of an organic material; and
c) forming a protective film at least on the organic material part.

8. The method as claimed in claim 7, **characterized in that** step a) includes a step of providing a MEMS element on the substrate.
